# EUROPÄISCHE PATENTSCHRIFT

(11) **EP 2 664 929 B1**
(45) Veröffentlichungstag und Bekanntmachung des Hinweises auf die Patenterteilung: **10.09.2014**
(21) Anmeldenummer: 12003837.7
(22) Anmeldetag: 15.05.2012
(51) Int. Cl.: G01R 1/36, G01R 31/327, H02H 9/04

(54) **Testgerät für energietechnische Einrichtungen und Verfahren zur Herstellung eines Testgeräts für energietechnische Einrichtungen**
Test device for energy devices and method for producing a test device for energy devices
Appareil de test pour installations techniques de production d'énergie et procédé de fabrication d'un appareil de test pour les installations techniques de production d'énergie

(43) Veröffentlichungstag der Anmeldung: 20.11.2013
(73) Patentinhaber: Omicron electronics GmbH, 6833 Klaus (AT)
(72) Erfinder: Flax, Dirk, 6850 Dornbirn (AT); Schedler, Horst, 6714 Nüziders (AT); Kaufmann, Reinhard, 6721 Thüringerberg (AT)
(74) Vertreter: Banzer, Hans-Jörg

(56) Entgegenhaltungen:
- EP-A1- 0 035 808
- EP-A1- 0 050 966
- EP-A2- 0 204 675
- WO-A1-00/74192
- CN-U- 201 699 254
- US-A- 3 417 277
- US-A- 5 479 315
- US-B1- 6 445 196

## Beschreibung

Die Erfindung betrifft ein Testgerät für energietechnische Einrichtungen und ein Verfahren zur Herstellung eines Testgeräts für energietechnische Einrichtungen. Insbesondere betrifft die vorliegende Erfindung ein Testgerät zum Testen bzw. Überprüfen von Betriebsmitteln in elektrischen Hoch- oder Mittelspannungssystemen, wie beispielsweise Leistungstransformatoren, Strom-/Spannungswandlern, Leistungsschaltern, Schutzrelais, Generatoren, Motoren oder Kabelsystemen etc. sowie ein Verfahren zur Herstellung eines derartigen Testgeräts.

In Testgeräten zum Testen von Betriebsmitteln in elektrischen Hoch- und Mittelspannungssystemen können häufig Überspannungen auftreten, welche über die Eingangs- oder Ausgangsbuchsen des Testgeräts in das jeweilige Testgerät gelangen und dort Komponenten des Testgeräts, insbesondere die Elektronik des Testgeräts, beschädigen oder sogar zerstören können. Daher werden in herkömmlichen Testgeräten Überspannung-Schutzelemente, wie beispielsweise Transzorbdioden oder Überspannungsgasableiter, eingebaut, um das Testgerät gegen derartige Überspannungen zu schützen.

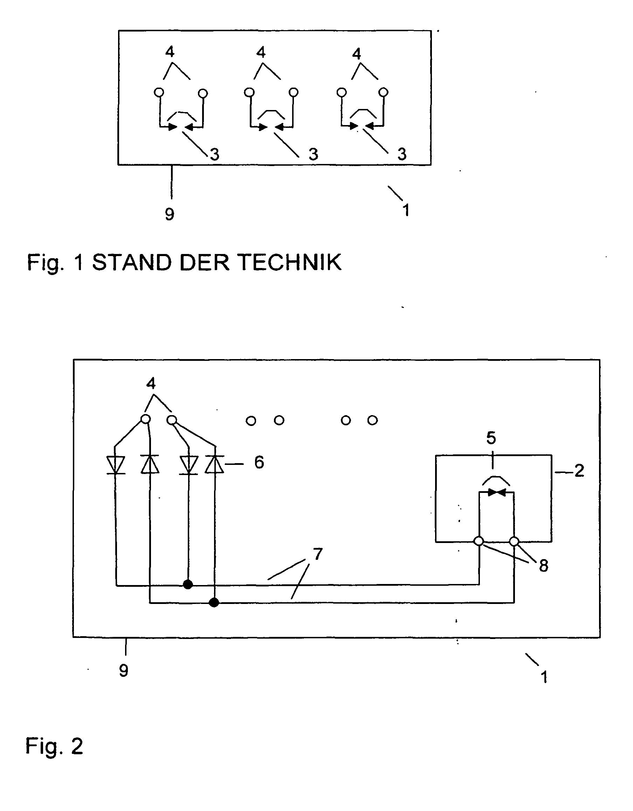

Figur 1 zeigt schematisch ein Testgerät 1 gemäß dem Stand der Technik, wobei das Testgerät 1 ein Gehäuse 9 mit mehreren Buchsen 4 aufweist, an welche jeweils ein von dem Testgerät 1 auszuwertendes Eingangssignal angelegt werden kann.oder über die ein Prüfsignal von dem Testgerät 1 ausgegeben werden kann. Zum Schutz vor Überspannungen ist bei dem in Fig. 1 gezeigten Beispiel jede der Buchsen 4 mit einem in dem Gehäuse 9 fest verbauten Überspannung-Schutzelement 3 verbunden.

Bei jedem Schutzelement 3 kann es sich beispielsweise um einen Überspannungsgasableiter handeln. Bei Überspannungsgasableitern zündet bei Überschreiten einer bestimmten Spannung ein kleiner Lichtbogen, um die Überspannung gegen Erde abzuleiten. Derartige Überspannungsgasableiter können auch mit Kurzschlussfedern ausgerüstet sein. In diesem Fall schmilzt ein Abstandhalter, wenn der Lichtbogen zu lange vorhanden ist, und die Kurzschlussfeder kann die Kontakte des Überspannungsableiters kurzschließen. Die Überspannung wird dann nahezu Null, so dass die Elektronik des Testgeräts dauerhaft vor eine Störung geschützt werden kann.

Ebenso können als Schutzelemente 4 Transzorbdioden verwendet werden, welche eine spannungsbegrenzende Wirkung haben, jedoch bei Auftreten einer Überspannung oder Überlast zu einem elektrischen Kurzschluss führen.

Den herkömmlichen Überspannung-Schutzvorrichtungen ist gemeinsam, dass die jeweils verwendeten Schutzelemente ähnlich zu einer Sicherung bei Auftreten einer Überspannung zerstört werden, um das Testgerät vor der Überspannung zu schützen. Zur Wiederinstandsetzung eines Testgeräts, in dem ein derartiges Überspannung-Schutzelement durch eine Überspannung zerstört worden ist, muss das Gehäuse des Testgeräts geöffnet und eine aufwändige Reparatur durchgeführt werden.

US 6,445,196 B1 offenbart ein Testgerät, welches ein Gehäuse, eine Buchse, einen mit der Buchse elektrisch verbundenen varistor mit einer Sicherung umfasst, wobei der varistor austauschbar ist. Es ist daher Aufgabe der vorliegenden Erfindung, ein Testgerät für energietechnische Einrichtungen und ein Verfahren zu Herstellung eines Testgeräts für energietechnische Einrichtungen bereitzustellen, wobei dieses Problem beseitigt ist und das Testgerät auch nach Beschädigung oder Zerstörung eines Überspannung-Schutzelements auf einfache und kostengünstige Weise wieder instand gesetzt werden kann.

Diese Aufgabe wird durch ein Testgerät gemäß Anspruch 1 und durch ein Verfahren zur Herstellung eines Testgeräts gemäß Anspruch 8 gelöst. Weitere vorteilhafte Ausgestaltungen der Erfindung sind in den abhängigen Ansprüchen angegeben.

Erfindungsgemäß wird ein Testgerät für energietechnische Einrichtungen und ein Verfahren zur Herstellung eines Testgeräts für energietechnische Einrichtungen bereitgestellt, wobei das Testgerät mehrere Buchsen zum Empfangen eines Eingangssignals oder Ausgeben eines Ausgangssignals aufweist, welche mit einer Überspannung-Schutzvorrichtung elektrisch verbunden ist. Die Überspannung-Schutzvorrichtung weist mindestens ein Überspannung-Schutzelement auf und ist derart ausgestaltet, dass das mindestens eine Überspannung-Schutzelement austauschbar ist.

Somit kann das Testgerät auch nach einer Beschädigung oder Zerstörung des Überspannung-Schutzelements nach einer Überspannung ohne großen Aufwand ersetzt werden, so dass das Testgerät mit einfachen Mitteln und kostengünstig wieder instand gesetzt werden kann.

Als "Buchse" im Sinne der vorliegende Erfindung wird dabei allgemein jede Anschlusseinrichtung des Testgeräts verstanden, über welche ein dem Testgerät zuzuführendes Eingangssignal (beispielsweise ein von dem Testgerät auszuwertendes Messsignal) empfangen bzw. ein Ausgangssignal des Testgeräts (insbesondere ein an einen Prüfling anzulegendes Test- oder Prüfsignal) ausgegeben werden kann. Diese Anschlusseinrichtung kann somit auch einen Einbaustecker oder eine andere geeignete elektrische Verbindung umfassen.

Das Testgerät kann insbesondere als Testgerät zum Testen von energietechnischen Einrichtungen oder Betriebsmitteln von elektrischen Hoch- und Mittelspannungssystemen ausgestaltet sein.

Die Überspannung-Schutzvorrichtung des Testgeräts ist vorzugsweise derart ausgestaltet, dass der Tausch des Überspannung-Schutzelements wie ein Tausch einer Sicherung ohne Öffnen des Gehäuses des Testgeräts und ohne Werkzeug erfolgen kann. Allenfalls sind zum Austauschen des Überspannung-Schutzelements einfachste Mittel wie z.B. ein Schraubendreher erforderlich.

Die Buchsen sind mit dem mindestens einen Überspannung-Schutzelement der Überspannung-Schutzvorrichtung über eine Diodenanordnung verbunden sein, wobei die einzelnen Dioden Strom nur in eine Richtung passieren lassen und derart verschaltet sind, dass durch die Diodenanordnung ein zusätzlicher Schutz des Testgeräts gewährleistet ist.

Jede der Buchsen ist mit demselben Überspannung-Schutzelement elektrisch verbunden.

Vorzugsweise handelt es sich bei dem mindestens einen Überspannung-Schutzelement um eine Transzorbdiode oder um einen Überspannungsableiter bzw. Überspannungsgasableiter, wobei der Überspannungsgasableiter wahlweise eine Kurzschlussfeder aufweisen kann.

Die Erfindung wird nachfolgend anhand bevorzugter Ausführungsbeispiele unter Bezugnahme auf die Zeichnung näher beschrieben.
Fig. 1 zeigt schematisch ein Testgerät gemäß dem Stand der Technik.
Fig. 2 zeigt schematisch ein Testgerät für energietechnische Einrichtungen
Fig. 3 zeigt schematisch ein Testgerät für energietechnische Einrichtungen gemäß einem weiteren Ausführungsbeispiel der Erfindung.

Bei dem in Fig. 2 gezeigten Testgerät 1 ist an einem Gehäuse 9 des Testgeräts mindestens eine Buchse 4 vorgesehen. Dabei kann es sich um eine Eingangsbuchse zum Empfangen eines entsprechenden Eingangssignals handeln, um beispielsweise ein an einem (nicht gezeigten) Prüfling abgegriffenes Messsignal auszuwerten und die Funktionsfähigkeit bzw. den Zustand des Prüflings durch das Testgerät 1 zu überprüfen. Bei dem Prüfling kann es sich insbesondere um ein Betriebsmittel eines Mittel- oder Hochspannungssystems handeln, wie z.B. einen Leistungstransformator, einen Strom-/Spannungswandler, einen Leistungsschalter, ein Schutzrelais, einen Generator, einen Motor oder ein Kabelsystem etc. Ebenso kann es sich bei der Buchse 4 um eine Ausgangsbuchse des Testgeräts 1 handeln, über welche beispielsweise ein Prüf- oder Testsignal an den jeweiligen Prüfling ausgegeben werden kann.

Zum Schutz vor Überspannungen ist die Buchse 4 über Verbindungsleitungen 7 elektrisch mit einer Überspannung-Schutzvorrichtung 2 verbunden. Innerhalb der Überspannung-Schutzvorrichtung 2 befindet sich mindestens ein Überspannung-Schutzelement 5, welches beispielsweise eine Transzorbdiode oder ein Überspannungsableiter, insbesondere ein Überspannungsgasableiter, sein kann.

Die Überspannung-Schutzvorrichtung 2 ist vorzugsweise in Form eines austauschbaren Moduls in oder an dem Testgerät 1 angeordnet, so dass das Überspannung-Schutzelement 5 durch Austauschen des Moduls einfach und vorzugsweise ohne Werkzeug gewechselt werden kann, falls das Überspannung-Schutzelement 5 beschädigt oder zerstört sein sollte. Hierzu kann das Modul der Überspannung-Schutzvorrichtung 2 an geeigneten Stellen elektrische Kontakte 8 aufweisen, welche bei Einsetzen des Moduls das jeweilige Überspannung-Schutzelement 5 mit den Verbindungsleitungen 7 verbindet. Das Modul kann insbesondere mit Steckkontakten 8 versehen sein, so dass zum Auswechseln des Überspannung-Schutzelements 5 das Modul einfach aus dem Gehäuse 9 herausgezogen und durch ein neues Modul mit einem funktionsfähigen Überspannung-Schutzelement 5 ersetzt werden kann, welches anschließend in das Gehäuse 9 wieder hinein gesteckt wird. Selbstverständlich ist auch denkbar, nach Herausnehmen des Moduls lediglich das Überspannung-Schutzelement 5 zu wechseln und anschließend dasselbe Modul mit dem neuen Überspannung-Schutzelement wieder in das Gehäuse 9 einzusetzen.

Vorzugsweise ist die Anordnung und Ausgestaltung der Überspannung-Schutzvorrichtung 2 derart, dass die Überspannung-Schutzvorrichtung 2 bzw. das Überspannung-Schutzelement 5 ohne Öffnen des Gehäuses 9 des Testgeräts 1 wie eine Sicherung getauscht werden kann. Somit kann eine aufwändige Reparatur vermieden und das Testgerät 1 ohne großen Zeitaufwand wieder in Betrieb genommen werden.

Bei dem in Fig. 2 gezeigten Beispiel ist die Buchse 4 nicht direkt über die Verbindungsleitungen 7 mit der Überspannung-Schutzvorrichtung 2 verbunden, sondern über eine Diodenanordnung 6, wobei die einzelnen Dioden dieser Diodenanordnung 6 derart mit der Buchse 4 und den Verbindungsleitungen 7 verschaltet sind, dass durch die Dioden ein zusätzlicher Schutz des Testgeräts 1 gegeben ist.

Wie bereits beschrieben, kann es sich bei dem Überspannung-Schutzelement 5 um einen Überspannungsableiter, insbesondere einen Überspannungsgasableiter handeln. Bei Überspannungsgasableitern zündet bei Überschreiten einer bestimmten Spannung ein kleiner Lichtbogen, um die Überspannung gegen Erde abzuleiten. Derartige Überspannungsgasableiter können auch mit Kurzschlussfedern ausgerüstet sein. In diesem Fall schmilzt ein Abstandhalter, wenn der Lichtbogen zu lange vorhanden ist, und die Kurzschlussfeder kann die Kontakte des Überspannungsableiters kurzschließen. Die Überspannung wird dann nahezu Null, so dass die Elektronik des Testgeräts dauerhaft vor eine Störung geschützt werden kann.

Ebenso kann als Überspannung-Schutzelement 5 eine Transzorbdiode verwendet werden, welche eine spannungsbegrenzende Wirkung hat, jedoch bei Auftreten einer Überspannung oder Überlast zu einem elektrischen Kurzschluss führt.

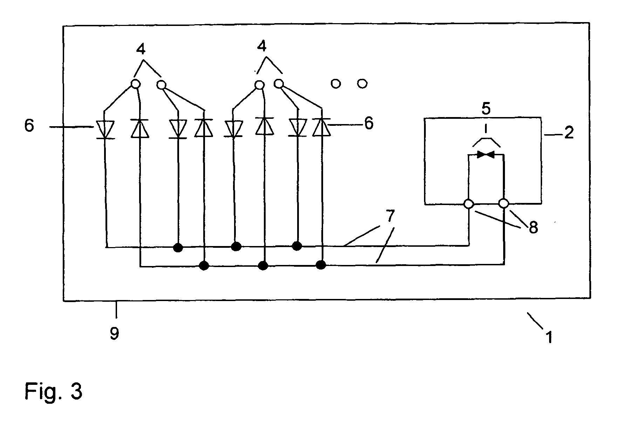

Figur 3 zeigt ein Ausführungsbeispiel der vorliegenden Erfindung.

Das in Fig. 3 gezeigte Testgerät 1 weist mehrere Buchsen 4 auf, welche jeweils über Diodenanordnungen 6 mit ein und demselben Überspannung-Schutzelement 5 einer Überspannung-Schutzvorrichtung 2 verbunden sind. Ansonsten entspricht das in Fig. 3 gezeigte Ausführungsbeispiel der Ausführungsform von Fig. 2, so dass vollinhaltlich auf die vorhergehenden Ausführungen zu Fig. 2 verwiesen werden kann.

## Patentansprüche

1. Testgerät (1) zum Testen von energietechnischen Einrichtungen, umfassend
ein Gehäuse (9),
mehrere Buchsen (4), welche jeweils zwei elektrische Kontakte zum Empfangen eines auszuwertenden Messsignals oder Ausgeben eines Testsignals aufweisen, und
eine über eine Diodenanordnung (6) mit den mehreren Buchsen (4) elektrisch verbundene gemeinsame Überspannung-Schutzvorrichtung (2) mit mindestens einem gemeinsamen Überspannung-Schutzelement (5), wobei jeder elektrische Kontakt jeder Buchse (4) über ein Paar von entgegengesetzt verschalteten Dioden der Diodenanordnung (6) mit elektrischen Kontakten (8) der Überspannung-Schutzvorrichtung (2) verbunden ist,
wobei die Überspannung-Schutzvorrichtung (2) derart ausgestaltet ist, dass das mindestens eine Überspannung-Schutzelement (5) austauschbar ist.

2. Testgerät (1) nach Anspruch 1,
**dadurch gekennzeichnet,**
**dass** das Testgerät (1) als Testgerät zum Testen von Betriebsmitteln eines elektrischen Hoch- oder Mittelspannungssystems ausgestaltet ist.

3. Testgerät (1) nach Anspruch 1 oder Anspruch 2,
**dadurch gekennzeichnet,**
**dass** die Überspannung-Schutzvorrichtung (2) derart ausgestaltet ist, dass das mindestens eine Überspannung-Schutzelement (5) ohne Öffnen des Gehäuses (9) des Testgeräts (1) auswechselbar ist.

4. Testgerät (1) nach einem der vorhergehenden Ansprüche,
**dadurch gekennzeichnet,**
**dass** das mindestens eine Überspannung-Schutzelement (5) der Überspannung-Schutzvorrichtung (2) eine Suppressordiode umfasst.

5. Testgerät (1) nach einem der Ansprüche 1-3,
**dadurch gekennzeichnet,**
**dass** das mindestens eine Überspannung-Schutzelement (5) der Überspannung-Schutzvorrichtung (2) einen Überspannungsgasableiter umfasst.

6. Testgerät (1) nach Anspruch 5,
**dadurch gekennzeichnet,**
**dass** der Überspannungsgasableiter eine Kurzschlussfeder aufweist.

7. Testgerät (1) nach einem der vorhergehenden Ansprüche,
**dadurch gekennzeichnet,**
**dass** die Überspannung-Schutzvorrichtung (2) mit dem mindestens einen Überspannung-Schutzelement (5) in einem Modul untergebracht ist, welches in dem Gehäuse (9) austauschbar angeordnet ist.

8. Verfahren zur Herstellung eines Testgeräts (1) zum Testen von energietechnischen Einrichtungen, umfassend die Schritte Bereitstellen eines Gehäuses (9) mit mehreren Buchsen (4), welche jeweils zwei elektrische Kontakte zum Empfangen eines auszuwertenden Messsignals oder zum Ausgeben eines Testsignals aufweisen,
Anordnen einer Überspannung-Schutzvorrichtung (2) mit mindestens einem Überspannung-Schutzelement (5) an oder in dem Gehäuse (9), und
elektrisches Verbinden von jeder Buchse (4) über eine Diodenanordnung mit dem mindestens einen Überspannung-Schutzelement (5) der Überspannung-Schutzvorrichtung (2), wobei jeder elektrische Kontakt jeder Buchse (4) über ein Paar von entgegengesetzt verschalteten Dioden der Diodenanordnung (6) mit elektrischen Kontakten (8) der Überspannung-Schutzvorrichtung (2) verbunden ist, wobei die Überspannung-Schutzvorrichtung (2) derart an oder in dem Gehäuse (9) angeordnet wird, dass das mindestens eine Überspannung-Schutzelement (5) austauschbar ist.

9. Verfahren nach Anspruch 8,
**dadurch gekennzeichnet,**
**dass** das Verfahren zur Herstellung eines Testgeräts (1) nach einem der Ansprüche 2-7 ausgestaltet ist.

## Claims

1. A test device (1) for testing power engineering equipment, comprising
a housing (9),
a plurality of sockets (4) which each comprise two electrical contacts for receiving a measurement signal to be evaluated or for outputting a test signal, and
a common overvoltage protection arrangement (2) comprising at least one common overvoltage protection element (5), the overvoltage protection arrangement (2) being electrically connected to the plurality of sockets (4) via a diode arrangement (6), wherein each electrical contact of each socket (4) is connected to electrical contacts (8) of the overvoltage protection arrangement (2) via a pair of oppositely connected diodes of the diode arrangement (6),
wherein the overvoltage protection arrangement (2) is configured such that the at least one overvoltage protection element (5) is exchangeable.

2. The test device (1) according to claim 1,
**characterized in that**
the test device (1) is configured as a test device for testing operating resources of an electrical high or medium voltage system.

3. The test device (1) according to claim 1 or claim 2,
**characterized in that**
the overvoltage protection arrangement (2) is configured such that the at least one overvoltage protection element (5) is exchangeable without having to open the housing (9) of the test device (1).

4. The test device (1) according to any one of the preceding claims,
**characterized in that**
the at least one overvoltage protection element (5) of the overvoltage protection arrangement (2) comprises a suppressor diode.

5. The test device (1) according to any one of claims 1-3,
**characterized in that**
the at least one overvoltage protection element (5) of the overvoltage protection arrangement (2) comprises an overvoltage gas arrestor.

6. The test device (1) according to claim 5,
**characterized in that**
the overvoltage gas arrestor comprises a short-circuit spring.

7. The test device (1) according to any one of the preceding claims,
**characterized in that**
the overvoltage protection arrangement (2) is accommodated with the at least one overvoltage protection element (5) in a module which is arranged exchangeable in the housing (9).

8. A method for manufacturing a test device (1) for testing power engineering equipment, comprising the steps
providing a housing (9) having a plurality of sockets (4) which each comprise two electrical contacts for receiving a measurement signal to be evaluated or for outputting a test signal,
arranging an overvoltage protection arrangement (2) with at least one overvoltage protection element (5) at or in the housing (9), and
electrically connecting each socket (4) to the at least one overvoltage protection element (5) of the overvoltage protection arrangement (2) via a diode arrangement, each electrical contact of each socket (4) being connected to electrical contacts (8) of the overvoltage protection arrangement (2) via a pair of oppositely connected diodes of the diode arrangement (6),
wherein the overvoltage protection arrangement (2) is arranged such at or in the housing (9) that the at least one overvoltage protection element (5) is exchangeable.

9. The method according to claim 8,
**characterized in that**
the method is configured for manufacturing a test device (1) according to any one of claims 2-7.

## Revendications

1. Appareil de test (1) pour tester des installations de technique énergétique, comprenant
un boîtier (9),
plusieurs prises (4), lesquelles présentent respectivement deux contacts électriques pour la réception d'un signal de mesure à analyser ou pour l'émission d'un signal de test, et
un dispositif de protection contre les surtensions (2) commun en liaison électrique, via un agencement de diodes (6), avec les plusieurs prises (4), avec au moins un élément de protection contre les surtensions (5) commun, chaque contact électrique de chaque prise (4) étant en liaison, via une paire de diodes de l'agencement de diodes (6) couplées de manière antagoniste, avec des contacts électriques (8) du dispositif de protection contre les surtensions (2),
le dispositif de protection contre les surtensions (2) étant réalisé de manière à ce que l'au moins un élément de protection contre les surtensions (5) soit remplaçable.

2. Appareil de test (1) selon la revendication 1,
**caractérisé en ce que**
l'appareil de test (1) est réalisé en tant qu'appareil de test pour tester des moyens d'exploitation d'un système électrique de haute ou moyenne tension.

3. Appareil de test (1) selon la revendication 1 ou la revendication 2,
**caractérisé en ce que**
le dispositif de protection contre les surtensions (2) est réalisé de manière à ce que l'au moins un élément de protection contre les surtensions (5) peut être remplacé sans ouvrir le boîtier (9) de l'appareil de test (1).

4. Appareil de test (1) selon l'une des revendications précédentes,
**caractérisé en ce que**
l'au moins un élément de protection contre les surtensions (5) du dispositif de protection contre les surtensions (2) comprend une diode de suppression.

5. Appareil de test (1) selon l'une des revendications 1 à 3,
**caractérisé en ce que**
l'au moins un élément de protection contre les surtensions (5) du dispositif de protection contre les surtensions (2) comprend un limiteur de gaz de surtension.

6. Appareil de test (1) selon la revendication 5,
**caractérisé en ce que**
le limiteur de gaz de surtension présente un ressort de court-circuit.

7. Appareil de test (1) selon l'une des revendications précédentes,
**caractérisé en ce que**
le dispositif de protection contre les surtensions (2) avec l'au moins un élément de protection contre les surtensions (5) est logé dans un module, lequel est disposé de manière remplaçable dans le boîtier (9).

8. Procédé pour la fabrication d'un appareil de test (1) pour tester des installations de technique énergétique, comprenant les étapes de :
mise à disposition d'un boîtier (9) avec plusieurs prises (4), lesquelles présentent respectivement deux contacts électriques pour la réception d'un signal de mesure à analyser ou pour l'émission d'un signal de test,
mise en place d'un dispositif de protection contre les surtensions (2) avec au moins un élément de protection contre les surtensions (5) sur ou dans le boîtier (9), et
raccordement électrique de chaque prise (4) par l'intermédiaire d'un agencement de diodes à l'au moins un élément de protection contre les surtensions (5) du dispositif de protection contre les surtensions (2), chaque contact électrique de chaque prise (4) étant connecté, via une paire de diodes de l'agencement de diodes (6) couplées de manière antagoniste, à des contacts électriques (8) du dispositif de protection contre les surtensions (2),
le dispositif de protection contre les surtensions (2) étant mis en place sur ou dans le boîtier (9) de manière à ce que l'au moins un élément de protection contre les surtensions (5) soit remplaçable.

9. Procédé selon la revendication 8,
**caractérisé en ce que**
le procédé est conçu pour la fabrication d'un appareil de test (1) selon l'une des revendications 2 à 7.
